# EUROPEAN PATENT APPLICATION

(11) **EP 4 704 350 A1**
(43) Date of publication of application: **04.03.2026**
(21) Application number: 24306404.5
(22) Date of filing: 28.08.2024
(51) Int. Cl.: H04B 5/24, H04B 5/77, H04B 17/14, H04B 5/48

(54) **AN APPARATUS**

(71) Applicant: NXP B.V., 5656 AG Eindhoven (NL)
(72) Inventor: JAMIN,, Olivier Jérôme Célestin, 31023 Toulouse (FR); LESELLIER,, Amandine, 31023 Toulouse (FR)
(74) Representative: Krott, Michel

(57) **Abstract**

An apparatus comprising: a transmitter; a DC-DC converter configured to generate, based on a switching schedule, an output voltage for said transmitter element; a receiver path to sample a received signal based on a sampling schedule; a noise detector to measure receiver path noise; a controller to perform a calibration process comprising: acquire a first measurement of receiver path noise for a first candidate offset setting, wherein the first candidate offset setting defines a first time offset applied to default timing of one of the switching schedule and the sampling schedule; acquire a second measurement of receiver path noise for a second candidate offset setting that defines a second, different, time offset applied to default timing of the switching schedule and the sampling schedule; and select, for use in sampling the received signal, one of the first or second candidate offset setting based on a noise-based criteria.

## Description

### Field

The present disclosure relates to an apparatus comprising a DC-DC converter, a transmitter element and a receiver path. In particular, it relates to an apparatus comprising a controller for mitigating against noise when a DC-DC converter, a transmitter element and a receiver path are co-located.

### Background

A DC-DC converter, a transmitter element and a receiver path may be co-located, such as on the same die. Some applications, such as Near-Field Communication, NFC, readers or Radio Frequency Identification, RFID, readers, require a large transmit power and are required to receive a response signal of much smaller magnitude. The co-location of the components and the disparity in transmit signal and receive signal strengths presents a challenge.

### Summary

According to a first aspect of the present disclosure there is provided an apparatus comprising:
a transmitter element configured to generate one or both of a magnetic field or electromagnetic signal;
a switched mode DC-DC converter configured to generate, based on a switching schedule, an output voltage for said transmitter element to generate the magnetic field or electromagnetic signal or for other components of the apparatus;
a receiver path configured to sample a received signal over a plurality of sampling periods based on a sampling schedule;
a noise detector configured to measure noise in the receiver path;
a controller configured to perform a calibration process comprising:
   acquire a first measurement, by said noise detector, of noise in the receiver path for a first candidate offset setting, wherein the first candidate offset setting defines a first time offset applied to default timing of one of the switching schedule for DC-DC converter and the sampling schedule for the receiver path;
   acquire a second measurement, by said noise detector, of noise in the receiver path for a second candidate offset setting, wherein the second candidate offset setting defines a second, different, time offset applied to default timing of the one of the switching schedule for DC-DC converter and the sampling schedule for the receiver path; and
   select, for use in sampling the received signal, one of the first candidate offset setting and the second candidate offset setting based on which of the first measurement and the second measurement meets a noise-based criteria.

In one or more embodiments, the noise-based criteria comprises which of the first measurement and the second measurement is indicative of lower noise in the receiver path.

In one or more embodiments, the noise-based criteria comprises which of the first measurement and the second measurement is indicative of noise lower than a predetermined threshold level.

In one or more embodiments, the controller, by the acquiring of the first measurement using the first candidate offset setting and the second measurement using the second candidate offset setting, is configured to select the offset setting that provides for a change in state of a switch of the DC-DC converter, that is controlled by the switching schedule, that occurs at a different time to one or more of the sampling periods, wherein the offset setting defines a time offset applied to default timing of either of the switching schedule for DC-DC converter and the sampling schedule for the receiver path.

In one or more embodiments, the controller is configured to perform the calibration process at a time of start-up of the apparatus.

In one or more embodiments, the controller is configured to perform the calibration process based on one or more of:
(i) initialization of the apparatus;
(ii) a change, above a threshold, in a duty cycle of a switch of the switched mode DC-DC converter;
(iii) a change, above a threshold, in duty cycle, wherein the apparatus includes a sensor configured to measure a duty cycle of the DC-DC converter;
(iv) a change, above a threshold, in current in the transmitter element, wherein the apparatus includes a sensor configured to measure a current drawn by the transmitter element; and
(v) a change, above a threshold, in a battery voltage wherein the DC-DC converter receives the battery voltage as an input voltage for generating the output voltage.

In one or more embodiments, the receiver path comprises an in-phase, I, path and a quadrature, Q, path.

In one or more embodiments, the noise detector comprises a first noise detector configured to measure noise in the I path and a second noise detect configured to measure noise in the Q path.

In one or more embodiments, the receiver path comprises an in-phase, I, path and a quadrature, Q, path and wherein the noise detector is configured to measure noise in one of the I path and the Q path.

In one or more embodiments, the controller is configured to select said one of the first candidate offset setting and the second candidate offset setting further based on a receive path sampling condition comprising a peak sampling condition or a balanced sampling condition of the I path and the Q path.

In one or more embodiments, the controller is configured to acquire one or more further measurements, by said noise detector, of noise in the receiver path for one or more further candidate offset settings, the one or more further candidate offset settings each defining a different time offset applied to default timing of the one of the switching schedule for DC-DC converter and the sampling schedule for the receiver path; and
wherein the controller is configured to select, for use in sampling the received signal, one of the first candidate offset setting, the second candidate offset setting and the one or more further candidate offset settings based on which of the first measurement, the second measurement, and one or more further measurements meets the noise-based criteria.

In one or more embodiments, the switching schedule is provided by a switch control signal configured to control the switching of the DC-DC convertor; and the first time offset and the second time offset applied to default timing of the switching schedule is provided by applying a phase shift, corresponding to the respective first or second time offset, to the switch control signal.

In one or more embodiments, the sampling schedule is provided by a sampling control signal configured to define times when the receiver path performs sampling; and the first time offset and the second time offset applied to default timing of the switching schedule is provided by applying a phase shift, corresponding to the respective first or second time offset, to the sampling control signal.

In one or more embodiments, the first time offset comprises zero and thereby the acquisition of the first measurement is based on an initial switching schedule and an initial sampling schedule, wherein the switching schedule defines at least when a switch of the DC-DC converter changes state and the sampling schedule defines the points in time when the received signal is sampled over the plurality of sampling periods. In one or more embodiments, the second time offset is non-zero.

In one or more embodiments, the first measurement and the second measurement, and any further measurement, if present, comprises a measurement of noise variance.

In one or more embodiments, the appartus comprises a common clock configured to provide a clock signal to the receiver path and the DC-DC converter for determination of the switching schedule and the sampling schedule.

In one or more embodiments, the transmitter element, the switched mode DC-DC converter and the receiver path are provided in a single die.

In one or more embodiments, the transmitter element is configured to one or both of: generate the magnetic field to energise a near-field communication, NFC, target; and generate the electromagnetic signal to communicate with a radio-frequency identification, RFID, tag.

In one or more embodiments, the controller is configured to disconnect the receiver path from an antenna during the calibration process.

According to an aspect of the disclosure there is provided an electronic device including the apparatus of the first aspect configured to read one or both of an NFC target and a RFID tag.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

### Brief Description of the Drawings

One or more embodiments will now be described by way of example only with reference to the accompanying drawings in which:
Figure 1 shows an example embodiment of an apparatus including example DC-DC converter topologies;
Figure 2 shows a first diagram illustrating a switching schedule and a sampling schedule for different DC-DC converter duty cycles;
Figure 3 shows a second diagram illustrating a switching schedule and a sampling schedule for a first candidate offset setting and a second candidate offset setting applied to the switching schedule;
Figure 4 shows a third diagram illustrating a switching schedule and a sampling schedule for a first candidate offset setting and a second candidate offset setting applied to the sampling schedule;
Figure 5 shows more detail of the apparatus of figure 1;
Figure 6 shows a fourth diagram illustrating a switching schedule and a sampling schedule for a first candidate offset setting and a second candidate offset setting applied to the sampling schedule;
Figure 7 shows a diagram illustrating different receive path sampling conditions; and
Figure 8 shows an example flowchart illustrating operation of the apparatus.

### Detailed Description

The present examples relate to an apparatus comprising a transmitter, a receiver and a DC-DC converter co-located on the same die, wherein the DC-DC convertor is configured to provide a voltage for powering the transmitter. For example, the apparatus may comprise a Near-Field Communication, NFC, reader or Radio Frequency Identification, RFID, reader. However, in some examples, the integration of the components on the single die or otherwise in close proximity can cause problems, such as a degradation in receiver performance. For example, when an integration of a DC-DC converter with a high-power transmitter operates at the same time as a radio receiver, which is the case with NFC/RFID transceivers and full-duplex radios, achieving effective receiver performance can be a challenge. As an example, in an NFC reader, such as embedded in a mobile phone, the DC-DC converter may need to supply a transmitter with up to 3 Watts, in order to provide sufficient energy in the form of a magnetic field to a passive tag, while the receiver needs to demodulate a tiny response from the same tag, such as of the magnitude of a few µV or tens of µV. It will be appreciated that in other examples, not shown, that the DC-DC converter may be configured to provide a voltage for other components, other than the transmitter, such as digital components or low-voltage analog components.

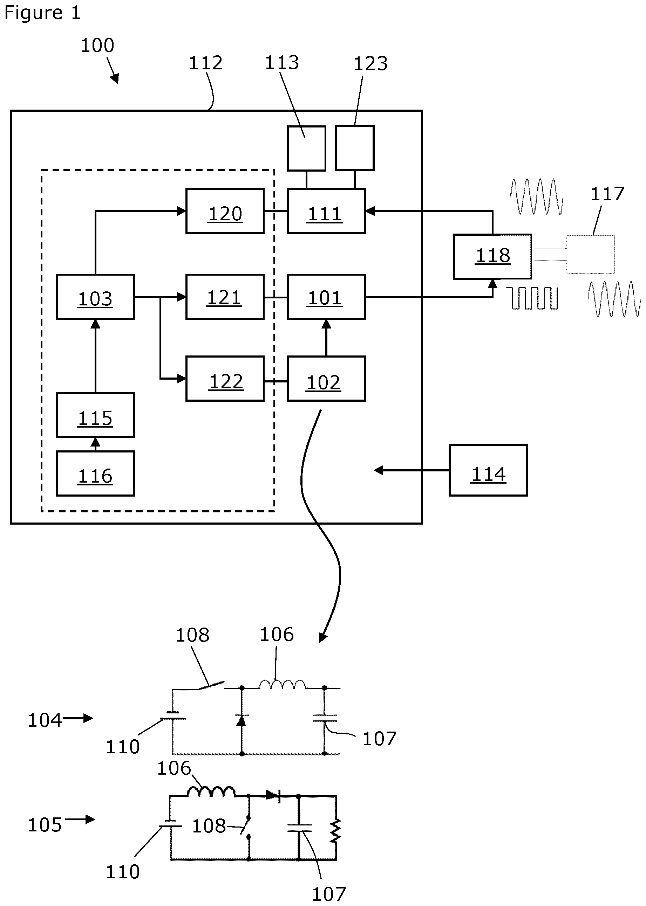

Figure 1 shows an example embodiment of an apparatus. The apparatus 100 comprises a transmitter element 101 configured to generate one or both of a magnetic field, such as for energising a NFC target tag, and an electromagnetic interrogation signal, such as to activate an RFID tag. The transmitter may comprise or include a low-drop output regulator. The apparatus 100 further comprises a switched mode DC-DC converter 102 configured to generate, based on a switching schedule, an output voltage for said transmitter element to generate the magnetic field or electromagnetic signal. The switching schedule may be implemented by a switch control signal provided that controls the state of the switch of the DC-DC converter. The DC-DC converter 102, in the present example, receives a clock signal from clock 103 and the switch control signal may be based, in part, on said clock signal.

As will be familiar to those skilled in the art of switched mode DC-DC converters 101, the converter includes a switch that is opened and closed in order to generate the output voltage based on an input voltage. The control of the switch may depend on the voltage level of an input voltage to the converter or the desired output voltage. Generally, the switching schedule may define the points in time the switch of the DC-DC converter is switched, such as to achieve a certain duty cycle and/or output voltage. The DC-DC converter may comprise one of a boost converter and a buck converter. Figure 1 also shows a first simple schematic of a buck type DC-DC converter 104 and a second simple schematic of a boost type DC-DC converter 105. In general, each DC-DC converter includes an energy storage element, comprising an inductor 106 and a capacitor 107 in the example schematics, and a switch 108. In the present examples, the input voltage may be provided by a battery 110. As mentioned and as will be familiar to those skilled, the DC-DC converter is configured to raise (or lower) the input voltage provided from the battery 110 to an output voltage level based on the action of the switch 108, wherein the switch 108 is controlled in accordance with the switching schedule (or switch control signal), and the energy stored in the energy storage element during cycles of switching.

The apparatus 100 further comprises a receiver path 111. The receiver path may comprise one or more components configured to receive the signal such as one or more filters, mixers and/or amplifiers, as would be familiar to those skilled in the art. The receiver path 111 is configured to sample a received signal over a plurality of sampling periods based on a sampling schedule. The sampling schedule may be implemented by one or more sampling control signals that define time periods when the receiver path is caused to sample the received signal. The receiver path 111 or components thereof, in the present example, receives the clock signal from clock 103 upon which the sampling control signals and therefore the sampling periods are based, at least in part. The clock 103 may generate the clock signal based on a phase locked loop 115 and crystal oscillator 116.

In the present example, the DC-DC converter 102, the transmitter element 101 and the receiver path 111 all receive a common clock signal from clock 103 and are therefore synchronous.

Further, the transmitter element 101 and the receiver path 111 are configured to be coupled to an antenna 117 via an impedance matching network 118.

In the present example, at least the DC-DC converter 102, the transmitter element 101 and the receiver path 111 are formed on the same single die 112. However, in other examples, they may be co-located in the same chip or PCB.

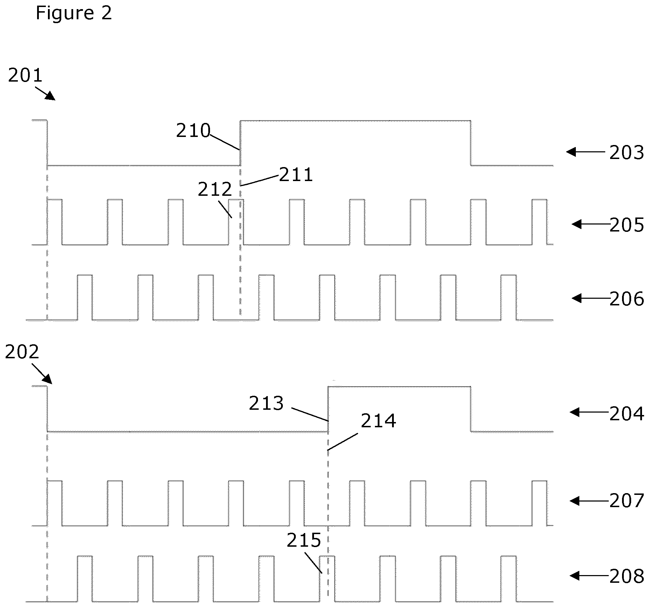

Figure 2 shows two example timing diagrams 201, 202 to illustrate an effect co-location has on noise. The timing diagram 201 illustrates a switching schedule that causes switching of the switch of the DC-DC converter 102 to achieve a 60% duty cycle. The timing diagram 202 illustrates the switching schedule that causes switching of the switch of the DC-DC converter 102 to achieve a 35% duty cycle.

Traces 203 and 204 illustrate the switch control signal and, therefore, the state of the switching of the DC-DC converter 102. In the present example, the receiver path 111 comprises an in-phase, I, path and a quadrature, Q, path. Accordingly, trace 205 shows the plurality of sampling periods, based on the sampling schedule, for the I path and trace 206 shows the plurality of sampling periods, based on the sampling schedule, for the Q path. Likewise, trace 207 shows the plurality of sampling periods, based on a sampling schedule, for the I path and trace 208 shows the plurality of sampling periods, based on a sampling schedule, for the Q path. In the present example, the receiver path samples the received signal when the traces 205, 206, 207, 208 are high. Thus, the sampling schedule, in this example, may be implemented by a I-sampling control signal and a Q-sampling control signal to define the sampling periods and thereby cause the receiver path to sample the I and Q signals respectively.

It will be appreciated that in embodiments having I and Q signals the first measurement may comprise an I- noise measurement and a Q- noise measurement. Likewise, the second measurement and any further measurements may comprise a I- noise measurement and a Q- noise measurement. The I and Q noise measurement may be combined or considered by the controller separately.

In timing diagram 201, an edge 210 representing a change in state of the switch of the DC-DC converter is temporally aligned with the sampling performed in the I-path as shown by dashed line 211 intersecting sampling period 212. Thus, interference or noise created by the edge 210 comprises an "aggressor" to the sampling of the I path. Accordingly, obtaining this sample with an acceptable SNR may be difficult. The Q-path, in this example, is not affected by the switching of the DC-DC converter.

In timing diagram 202, an edge 213 representing a change in state of the switch of the DC-DC converter is temporally aligned with the sampling performed in the Q-path as shown by dashed line 214 intersecting sampling period 215. Thus, interference or noise created by the edge 213 comprises an "aggressor" to the sampling of the Q path. Accordingly, obtaining this sample with an acceptable SNR may be difficult. The I-path, in this example, is not affected by the switching of the DC-DC converter.

In one or more examples, the apparatus 100 may be configured to locate the DC-DC converter edges 210, 213 outside of specific sensitive time periods; for instance, outside the sampling periods (such as sampling phases of an mixer of the receiver path) of the receiver path 111 or I and Q paths thereof.

Returning to Figure 1, the apparatus 100 comprises a noise detector 113 configured to measure noise and, in particular, noise variance, in the receiver path 111. In general, the apparatus 100 may be configured to use measurements of noise based on candidate switching schedules and/or sampling schedules to select one of the candidate switching schedules and/or sampling schedules with the lowest noise for sampling a received signal. Thus, the apparatus 100 may include a controller 114, which may or may not be on the same die 112. The controller 114 may be configured to control the switching schedule and/or sampling schedule.

In general, the controller 114 is configured to measure, using the noise detector, the noise in the receiver path for one or both of a plurality of candidate switching schedules and a plurality of candidate sampling schedules, wherein the candidate switching schedules and the candidate sampling schedules differ from one another in terms of a temporal offset. Further, the controller 114 is configured to select one of the one or both of a plurality of candidate switching schedules and a plurality of candidate sampling schedules that has a noise measurement that meets a threshold criteria (which may be the lowest noise of those measured or some other criteria). Once selected, the receiver path 111 may be configured to sample the received signal using the selected one of the one or both of a plurality of candidate switching schedules and a plurality of candidate sampling schedules. By testing multiple candidate schedules, the apparatus 100 may advantageously account for temperature induced changes in aggressor position and changes in aggressor position due to modification of the DC-DC converter duty cycle mainly caused by a change of its input or output voltage.

Thus, the controller 114 of the present example is configured to perform a calibration process wherein the controller 114 causes the noise detector 113 to acquire a first measurement of noise in the receiver path 111 for a first candidate offset setting. The first candidate offset setting defines a first time offset, relative to default timing, and applied to one of the switching schedule for DC-DC converter and the sampling schedule for the receiver path. It will be appreciated that the default timing may be any time reference point the apparatus uses for establishing the switching schedule and/or the sampling schedule. If the first candidate time offset setting is applied to the switching schedule, the first time offset may be implemented by applying a phase shift to the switch control signal. If the first candidate time offset setting is applied to the sampling schedule, the first time offset may be implemented by applying a phase shift to the sampling control signal (for I or Q or both if I and Q samples are taken).

The controller 114 in the present embodiment is configured to acquire a second measurement, using said noise detector 113, of noise in the receiver path 111 for a second candidate offset setting. The second candidate offset setting defines a second, different, time offset, relative to the default timing, and is similarly applied to the one of the switching schedule for DC-DC converter and the sampling schedule for the receiver path. Similarly, the second time offset of the second candidate offset setting may be implemented by applying a phase shift to the relevant control signal.

The controller 114 now has two (or more) measurements of noise in the receiver path for different time offsets between the switching schedule and the sampling schedule. Thus, the controller 114 can select the time offset that yields the lowest or otherwise preferred noise level.

Accordingly, the controller is configured to select, for use in future sampling of the received signal, one of the first candidate offset setting and the second candidate offset setting based on which of the first measurement and the second measurement meets a noise-based criteria. Thus, if the first measurement meets the noise-based criteria, then the first candidate offset setting may be applied to the sampling schedule or switching schedule for when the received signal is sampled. Likewise, if the second measurement meets the noise-based criteria, then the second candidate offset setting may be applied to the sampling schedule or switching schedule for when the received signal is sampled.

The apparatus 100 may include one or more phase shifters 120, 121 and 122 for achieving the different candidate time offsets applied to the sampling schedule and switching schedule. It will be appreciated that the phase shifters 120, 121, 122 may shift the phase of the clock signal from clock 103 to achieve the desired candidate and, ultimately selected, time offset for application to the sampling schedule or switching schedule.

It will be appreciated that in some examples the calibration process may be performed based on transmission of a carrier signal and receipt of unmodulated carrier signals of the received signal rather than a received signal that contains data. In other examples, the controller 114 may be configured to disconnect the receiver path 111 from the antenna 117 and, optionally, the matching network 118, while said noise detector 113 makes said first measurement and said second measurement of the noise in the receive path during the calibration process.

The noise-based criteria for selecting which of the first time offset or second time offset to proceed with and measure the received signal may differ between example embodiments.

Thus, the noise-based criteria may comprise which of the first measurement and the second measurement (and any further measurements, if acquired) is indicative of lower (or the lowest) noise in the receiver path 111.

In another example, the noise-based criteria may comprise which of the first measurement and the second measurement (and any further measurements if acquired) is indicative of noise lower than a predetermined threshold level. In this second example embodiment, there may be two measurements (or more if more candidate offset settings are tested) that meet the predetermined threshold level of noise and therefore two corresponding time offsets may be available for selection. In some examples, the controller 114 may select either of them. In other examples, the noise-based criteria may define further rules that may be applied by the controller to make the selection.

In some examples, a measurement from the noise detector 113 may be acquired, as described above, but without any time offset applied, for example, using predetermined default timings for the DC-DC converter switching schedule and the receiver path 111 sampling schedule. Thus, in some examples this may be realised by the first time offset comprising zero and thereby the acquisition of the first measurement is based on a default switching schedule and default sampling schedule. The second time offset may therefore, in effect, be applied to the switching schedule and the sampling schedule having the default timing.

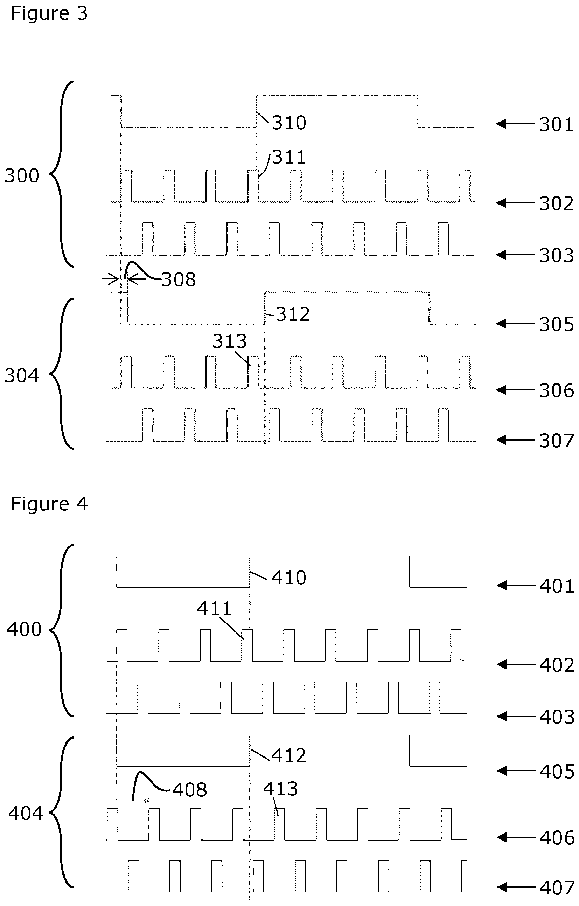

Figure 3 shows an example in which candidate time offsets are applied to the DC-DC converter switching schedule. Figure 4 shows an example in which the candidate time offsets are applied to the sampling schedule of the receiver path 111.

Figure 3 shows a first group of traces 300 comprising trace 301 illustrating the switch control signal of the switching schedule, a trace 302 illustrating the sampling schedule for the I path (I-sampling control signal) of the receiver path 111, and a trace 303 illustrating the sampling schedule for the Q path (Q-sampling control signal) of the receiver path 111. In this first group, no time offset is applied to the sampling schedule or switching schedule and therefore the traces represent default timings for said schedules.

Figure 3 also shows a second group of traces 304 comprising trace 305 illustrating the switching schedule, a trace 306 illustrating the sampling schedule for the I path of the receiver path 111, and a trace 307 illustrating the sampling schedule for the I path of the receiver path 111. In this second group 304, a second time offset 308 is applied to the default timings of the switching schedule (which may be implemented as a phase shift to the switch control signal).

For first group 300, it can be seen that edge 310 may cause noise for the sampling period 311 when no time offset is applied, which can be detected by the first measurement of noise. However, with reference to the second group 304, it can be seen that the second time offset 308 has shifted the edge 312 away from the sampling period 313. Thus, it would be expected that the second measurement of noise will be lower and therefore the second measurement and corresponding second time offset 308 will be selected by the controller 114 to be applied to the switching schedule when the received signal is sampled.

Figure 4 shows a first group of traces 400 comprising trace 401 illustrating the switching schedule, a trace 402 illustrating the sampling schedule for the I path of the receiver path 111, and a trace 403 illustrating the sampling schedule for the Q path of the receiver path 111. In this first group, no time offset is applied to the sampling schedule or switching schedule and therefore the traces represent default timings for said schedules.

Figure 4 also shows a second group of traces 404 comprising trace 405 illustrating the switching schedule, a trace 406 illustrating the sampling schedule for the I path of the receiver path 111, and a trace 407 illustrating the sampling schedule for the Q path of the receiver path 111. In this second group 404, a second time offset 408 is applied to the default timings of the sampling schedule, which time shifts the I and Q sampling periods.

For first group 400, it can be seen that edge 410 may cause noise for the sampling period 411 when no time offset is applied, which can be detected by the first measurement. However, with reference to the second group 404, it can be seen that the second time offset 408 has shifted the edge 412 away from the sampling period 413. Thus, it would be expected that the second measurement of noise will be lower and therefore the second measurement and corresponding second time offset 408 will be selected by the controller 114 to be applied to the sampling schedule when the received signal is sampled.

In these figures 3 and 4 the apparatus makes a first measurement with zero time offset and a second measurement with a second time offset. However, the first measurement may include a time offset other than zero. In addition, it will be appreciated that further candidate offset settings may be applied and the corresponding measurements made. Thus, in other examples, the controller 114 is configured to acquire one or more further measurements using the noise detector 113 of noise in the receiver path 111 based on one or more further candidate offset settings. Likewise, the one or more further candidate offset settings each define a different time offset relative to a default timing that is applied to one of the switching schedule and the sampling schedule.

Accordingly, the controller 114 may additionally have the one or more further measurements to consider for selecting which of the first, second and further measurements meets the noise-based criteria, and subsequently the associated candidate offset setting.

Thus, to summarise what the controller 114 may be configured to achieve, as illustrated in Figures 3 and 4, the controller 114, by the acquiring of the first measurement using the first candidate offset setting and the second measurement using the second candidate offset setting, is configured to select the time offset setting that provides for a change in state of a switch of the DC-DC converter 102 (that is controlled by the switching schedule) at a different time to one or more of the sampling periods determined based on the noise measurement and the noise-based criteria.

The calibration process may be triggered at different times. The controller 114 may be configured to perform the calibration process at a time of initialization or power-on of the apparatus 100. In other examples, a change in the duty cycle of the DC-DC converter 102 can lead to temporal movement of the edges 310, 410. Accordingly, the controller 114 may be configured or triggered to perform the calibration process based on a change, above a threshold, in a duty cycle of the switch 108 of the switched mode DC-DC converter. The DC-DC converter 102 may inform the controller 114 when the duty cycle changes or, alternatively, a sensor (not shown) may be provided to measure the duty cycle (or changes therein) such that the controller 114 may activate the calibration process. Further, a change, above a threshold, in current in the transmitter element 101 may be indicative of a change in the temporal position of the edges 310, 410 and may therefore be used by the controller 114 to trigger the calibration process. The apparatus may include a sensor (not shown) configured to measure a current drawn by the transmitter element 101 for determining triggering of the calibration process. In the present examples, the DC-DC converter receives its input voltage from a battery. Changes in battery voltage may require changes in the duty cycle and switching timings of the switching schedule to maintain an output voltage. Accordingly, there is a potential for "aggressor" edges to become aligned with sampling periods based on changes in battery voltage. Thus, the controller 114 may be configured to perform the calibration process based on a change, above a threshold, in the battery voltage. It will be appreciated that embodiments may include one or more of the above triggers for the calibration process. Other triggers are possible.

Thus, the embodiments described herein define an on-line calibration process, which may be compliant with ISO 14443 standard (NFC PHY). The controller 114 makes the measurements and selects the time offset that leads to an DC-DC converter switching schedule (in terms of its phase from relative to a default timing) which may provide the minimum noise perceived by a co-located receiver path 111. In other examples, the time offset is applied to the sampling schedule for the same purpose.

In addition, the sampling schedule for I and Q paths, comprising balanced sampling, or peak sampling, may be selected to provide improved SNR after IQ channel combining. In this way the embodiments provide a means to dynamically co-optimize the DC-DC converter and receiver path sampling to minimize the impact that a co-located DC-DC converter 102 interference has on a receiver path 111.

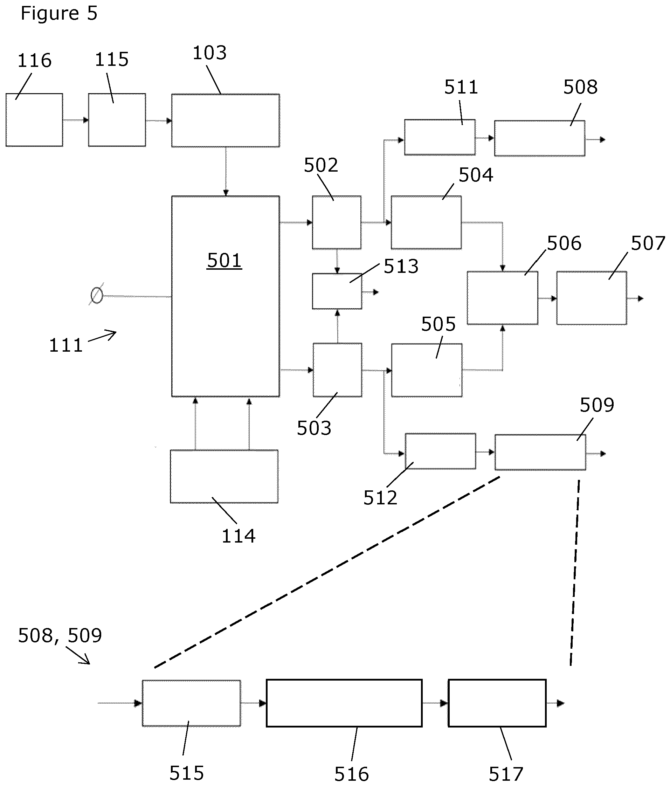

Figure 5 shows some of the components of the apparatus 100 in more detail. The figure shows the oscillator 116, the PLL 115 and the clock 103, as well as the controller 114. The remaining components comprise or are associated with the receiver path 111 and the noise detector 113. The apparatus may therefore comprise an I and Q analog receiver element 501 that receives the clock signal from the clock 103 and the instructions from the controller 114, such as the (e.g. I- and Q-) sampling control signal. The element 501 provides an analog I or in-phase signal to a first ADC 502 and an analog Q or quadrature signal to a second ADC 503. First and second signal conditioners 504 and 505 receive the digitized I and Q samples. An IQ combiner 506 combines the I and Q samples and provides the combined signal to a decoder 507 for further processing.

The noise detector comprises a first noise detector 508 configured to measure noise in the I path and a second noise detector 509 configured to measure noise in the Q path. In some examples, one noise detector is provided to measure noise in one of the I path and the Q path. In the present examples, the noise detector(s) receive their input from the ADCs 502, 503 and, optionally, via a band pass filter 511, 512. The band pass filter may be configured to select the bandwidth of the received signal so that the noise that is measured is noise that will impact the received signal. The filters 511, 512 can be FIR or IIR, with fixed or configurable taps.

Figure 5 also shows an example block diagram of the noise detector 508, which in this example comprises a noise variance detector. The noise detector 508 is configured to square or take the absolute value of the ADC output at block 515. The signal is then accumulated across a measurement time window by block 516. The accumulated signal is then finally scaled to a level which is independent of the integration time by block 517. A simplified implementation would limit the accumulation in block 516 to being over N samples where N is a power of 2 in order to simplify the division by N in block 517 to a simple bit shift.

To summarise the operation of the apparatus 100:
- The DC-DC converter 102, transmitter element 101 and receiver path 111 are turned ON.
- The DC-DC converter, transmitter element 101 & receiver path are configured based on the default timings. The transmitter element 101 is configured to transmit an unmodulated field. This may correspond to the start of a transaction, as specified in ISO 14443.
- The receiver path 111 synchronously receives the unmodulated carrier. Signals that are down-converted on I & Q paths of the receiver path will contain any noise/interference generated by the DC-DC converter 102 which is coupled to the receiver path 111.
- The two integrated noise variance detectors 113, 508, 509 measure the received noise on I & Q path.
- Different candidate offset settings are applied and noise variance detectors 113, 508, 509 measure the received noise on I & Q path
- The candidate offset settings that provide the preferred noise value can be selected.

In some examples, the apparatus 100, by way of block 123 in Figure 1, may be configured to determine the receive path sampling condition. In other examples, the controller may be configured to control the sampling schedule to achieve a peak or balanced sampling condition for sampling of the I and Q signals.

Thus, in some examples, the sampling schedule for the I and Q phases can be configured to influence the optimum IQ combiner 506 behaviour that occurs when the modulated signal (RFID card / NFC target response) is applied to the receiver. The change of phase or time offset of the sampling schedule, while keeping the transmitter phase unchanged, can move the sampling point of the receiver path on the carrier cycle

For instance, in a first/default scenario, the receive path sampling condition might be configured based on a balanced sampling condition (wherein the magnitudes of the carrier amplitude sampled on I & Q are equal). The IQ combiner 506 could be configured to equally add I & Q, either linearly or quadratically. An AM modulation would therefore result into equal modulation amplitude on I & Q.

In a second configuration, the receive path sampling condition might be configured based on a peak sampling condition (peak sampling on I, zero sampling on Q or vice versa). The IQ combiner could be configured to keep only I while discarding Q since Q, being at zero-crossing, does not carry any AM modulation produced by a tag response (or vice versa). In this second example, it is of no consequence if the edge 310, 410 is temporally overlapping with the sample period for the to-be-discarded Q sample. Accordingly, the controller 114 may be configured to select said one of the first candidate offset setting and the second candidate offset setting (and any further candidate offset settings) further based on the receive path sampling condition comprising a peak sampling condition or a balanced sampling condition of the I path and the Q path.

A cordic 123, 513 may be used to determine the receive path sampling condition.

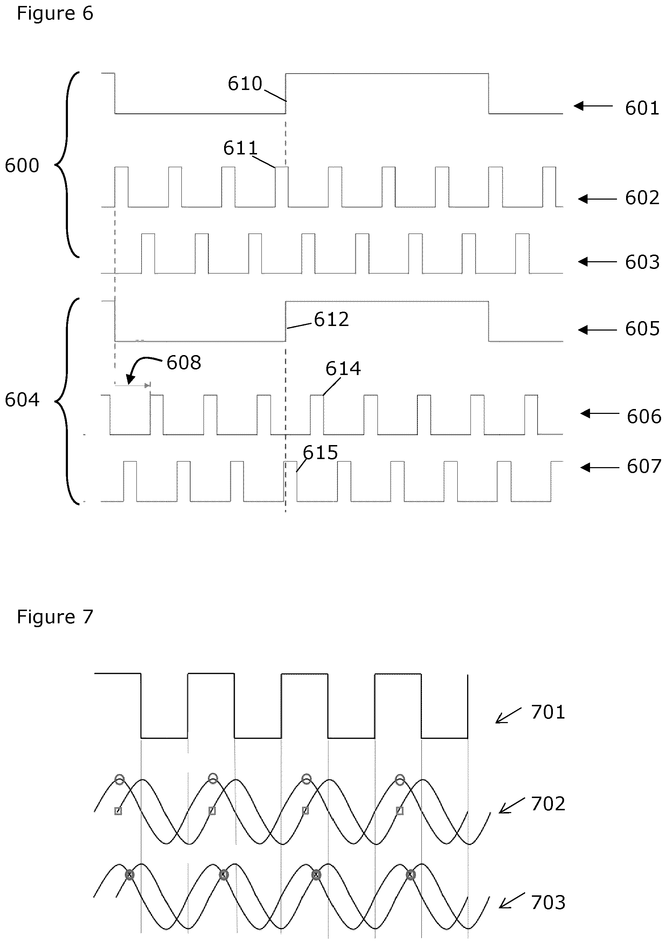

Figure 6 shows an example in which candidate time offsets are applied to the DC-DC converter switching schedule. Figure 6 shows an example in which the candidate time offsets are applied to the sampling schedule of the receiver path.

Figure 6 shows a first group of traces 600 comprising trace 601 illustrating the switching schedule, a trace 602 illustrating the sampling schedule for the I path of the receiver path 111, and a trace 603 illustrating the sampling schedule for the Q path of the receiver path 111. In this first group, no time offset is applied to the sampling schedule or switching schedule and therefore the traces represent default timings for said schedules.

Figure 6 also shows a second group of traces 604 comprising trace 605 illustrating the switching schedule, a trace 606 illustrating the sampling schedule for the I path of the receiver path 111, and a trace 607 illustrating the sampling schedule for the Q path of the receiver path 111. In this second group 604, a second time offset 608 is applied to the default timings of the switching schedule.

For first group 600, it can be seen that edge 610 may cause noise for the sampling period 611 when no time offset is applied, which can be detected by the I-path first measurement. However, with reference to the second group 604, it can be seen that the second time offset 308, 608 has shifted the edge 612 away from the sampling period 313. Instead, the edge 612 temporally overlaps with the Q path sampling period 615. Thus, it would be expected that the second measurement of noise will be lower on the I path but higher on the Q path. However, if the receive path sampling condition is indicative of the Q samples not being required, the controller 114 may select the second time offset 608 for future sampling of the received signal.

Thus, in general, the controller may be configured to select, for use in sampling the received signal, one of the first candidate offset setting and the second candidate offset setting based on which of the first measurement and the second measurement meets a noise-based criteria and a receive path sampling condition indicative of the sampling of one or both of an in phase path and a quadrature path.

Thus, it may only be necessary to determine the noise for one of the I and Q paths. This may be advantageous and provide more flexibility because if the samples from the I path are used and the samples from the Q path are not needed, it is of no consequence that the aggressor signal from the DC-DC converter lies within the sampling periods associated with the Q-path, for example.

Figure 7 shows a waveform 701 of the output from the transmitter element 101. The traces 702 show the I and Q carrier waves. The circle symbol shows the sampling point of the I path. The square symbol shows the sampling point of the Q path. In this example, the receive path sampling condition comprises peak sampling in the I path. Accordingly, the Q path is sampled at zero crossing and the AM response of a tag will have no information in the Q path and therefore an aggressor in the Q sampling period is of no consequence.

Trace 703 shows the receive path sampling condition of balanced sampling. In this scheme, the circle and square symbols overlap. With this receive path sampling condition, it may be preferred to ensure the edge 310, 312, 410, 412 is positioned away from both I and Q sample periods.

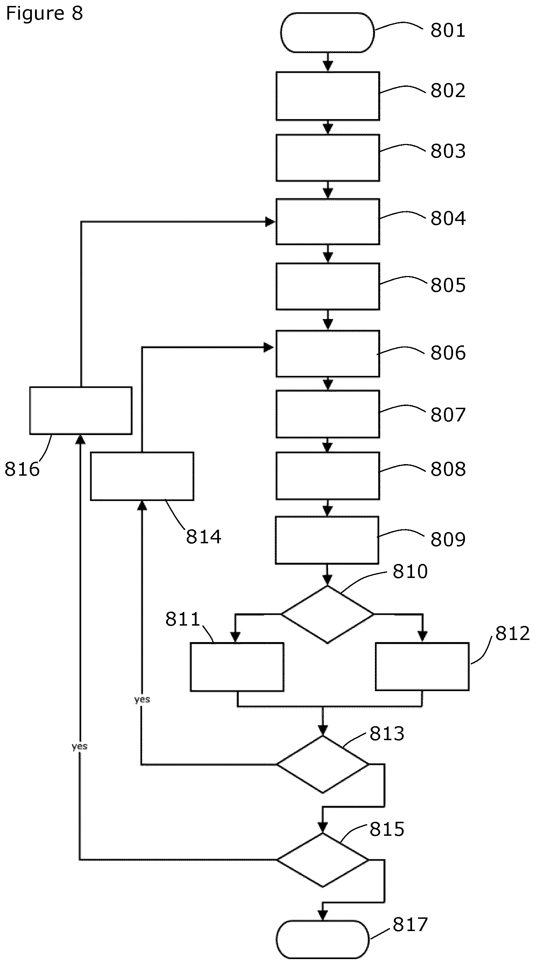

Figure 8 shows an example flowchart illustrating the calibration process. The process comprises: 801 - start of the processes; 802 - power amplifier initialisation; 803 - DC-DC converter and transmitter element start up; 804 - set the switching schedule to run with a default timing e.g. without a time offset or with a first time offset; 805 - set the transmitter element for transmission; 806 - set the sampling schedule to run with a default timing e.g. without a time offset or with a first time offset; 807 - start receiving; 808 - emit the transmitter carrier wave; 809 - measure the first measurement; 810 - determine the receive path sampling condition (peak sampling determined at 811 and balanced sampling determined at 812); 813 - have all the time offsets to the sampling schedule been provided? 814 - set a different time offset on the sampling schedule and return to step 806; alternatively, 815 - have all the time offsets to the switching schedule been provided?; if not: 816-set a different time offset on the switching schedule and return to step 804, if so: 817 - end the calibration process and determine the time offset to use.

The embodiments described herein do not require any Look Up Table, and they can adapt to potential drifts of the DC-DC converter duty cycle (caused by PVT or load current variations), as well as to PVT delay variation between receive path and DC-DC converter clocks.

In any of the embodiments, the transmitter element 101 may be configured to generate the magnetic field to energise a near-field communication, NFC, target or generate the electromagnetic signal to communicate with a radio-frequency identification, RFID, tag. Accordingly, the apparatus 100 may be part of an electronic device, such as a mobile phone. The mobile phone may this have the functionality to read one or both of an NFC target and a RFID tag.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. An apparatus comprising:
a transmitter element configured to generate one or both of a magnetic field or electromagnetic signal;
a switched mode DC-DC converter configured to generate, based on a switching schedule, an output voltage for said transmitter element to generate the magnetic field or electromagnetic signal or for other components of the apparatus;
a receiver path configured to sample a received signal over a plurality of sampling periods based on a sampling schedule;
a noise detector configured to measure noise in the receiver path;
a controller configured to perform a calibration process comprising:
acquire a first measurement, by said noise detector, of noise in the receiver path for a first candidate offset setting, wherein the first candidate offset setting defines a first time offset applied to default timing of one of the switching schedule for DC-DC converter and the sampling schedule for the receiver path;
acquire a second measurement, by said noise detector, of noise in the receiver path for a second candidate offset setting, wherein the second candidate offset setting defines a second, different, time offset applied to default timing of the one of the switching schedule for DC-DC converter and the sampling schedule for the receiver path; and
select, for use in sampling the received signal, one of the first candidate offset setting and the second candidate offset setting based on which of the first measurement and the second measurement meets a noise-based criteria.

2. The apparatus of claim 1, wherein the noise-based criteria comprises one of:
which of the first measurement and the second measurement is indicative of lower noise in the receiver path; and
which of the first measurement and the second measurement is indicative of noise lower than a predetermined threshold level.

3. The apparatus of claim 1 or claim 2, wherein the controller, by the acquiring of the first measurement using the first candidate offset setting and the second measurement using the second candidate offset setting, is configured to select the offset setting that provides for a change in state of a switch of the DC-DC converter, that is controlled by the switching schedule, that occurs at a different time to one or more of the sampling periods, wherein the offset setting defines a time offset applied to default timing of either of the switching schedule for DC-DC converter and the sampling schedule for the receiver path.

4. The apparatus of any preceding claim, wherein the controller is configured to perform the calibration process based on one or more of:
(i) initialization of the apparatus;
(ii) a change, above a threshold, in a duty cycle of a switch of the switched mode DC-DC converter;
(iii) a change, above a threshold, in duty cycle, wherein the apparatus includes a sensor configured to measure a duty cycle of the DC-DC converter;
(iv) a change, above a threshold, in current in the transmitter element, wherein the apparatus includes a sensor configured to measure a current drawn by the transmitter element; and
(v) a change, above a threshold, in a battery voltage wherein the DC-DC converter receives the battery voltage as an input voltage for generating the output voltage.

5. The apparatus of any preceding claim, wherein the receiver path comprises an in-phase, I, path and a quadrature, Q, path and wherein the noise detector comprises a first noise detector configured to measure noise in the I path and a second noise detect configured to measure noise in the Q path.

6. The apparatus of any preceding claim, wherein the receiver path comprises an in-phase, I, path and a quadrature, Q, path and wherein the noise detector is configured to measure noise in one of the I path and the Q path.

7. The apparatus of claim 5 or claim 6, wherein the controller is configured to select said one of the first candidate offset setting and the second candidate offset setting further based on a receive path sampling condition comprising a peak sampling condition or a balanced sampling condition of the I path and the Q path.

8. The apparatus of any preceding claim, wherein the controller is configured to acquire one or more further measurements, by said noise detector, of noise in the receiver path for one or more further candidate offset settings, the one or more further candidate offset settings each defining a different time offset applied to default timing of the one of the switching schedule for DC-DC converter and the sampling schedule for the receiver path; and
wherein the controller is configured to select, for use in sampling the received signal, one of the first candidate offset setting, the second candidate offset setting and the one or more further candidate offset settings based on which of the first measurement, the second measurement, and one or more further measurements meets the noise-based criteria.

9. The apparatus of any preceding claim, wherein the first time offset comprises zero and thereby the acquisition of the first measurement is based on an initial switching schedule and an initial sampling schedule, wherein the switching schedule defines at least when a switch of the DC-DC converter changes state and the sampling schedule defines the points in time when the received signal is sampled over the plurality of sampling periods.

10. The apparatus of any preceding claim, wherein the first measurement and the second measurement, and any further measurement, if present, comprises a measurement of noise variance.

11. The apparatus of any preceding claim, wherein the appartus comprises a common clock configured to provide a clock signal to the receiver path and the DC-DC converter for determination of the switching schedule and the sampling schedule.

12. The apparatus of any preceding claim, wherein the transmitter element, the switched mode DC-DC converter and the receiver path are provided in a single die.

13. The apparatus of any preceding claim, wherein the transmitter element is configured to one or both of: generate the magnetic field to energise a near-field communication, NFC, target; and generate the electromagnetic signal to communicate with a radio-frequency identification, RFID, tag.

14. The apparatus of any preceding claim, wherein the controller is configured to disconnect the receiver path from an antenna during the calibration process.

15. An electronic device including the apparatus of any preceding claim configured to read one or both of an NFC target and a RFID tag.

## Amended claims

### Amended claims in accordance with Rule 137(2) EPC.

1. An apparatus (100) comprising:
a transmitter element (101) configured to generate one or both of a magnetic field or electromagnetic signal;
a switched mode DC-DC converter (102) configured to generate, based on a switching schedule, an output voltage for said transmitter element (101) to generate the magnetic field or electromagnetic signal or for other components of the apparatus (100);
a receiver path (111) configured to sample a received signal over a plurality of sampling periods based on a sampling schedule;
a noise detector (113) configured to measure noise in the receiver path (111);
a controller (114) configured to perform a calibration process comprising:
acquire a first measurement, by said noise detector (113), of noise in the receiver path (111) for a first candidate offset setting, wherein the first candidate offset setting defines a first time offset applied to default timing of the sampling schedule for the receiver path;
acquire a second measurement, by said noise detector (113), of noise in the receiver path (111) for a second candidate offset setting, wherein the second candidate offset setting defines a second, different, time offset applied to default timing of the sampling schedule for the receiver path; and
select, for use in sampling the received signal, one of the first candidate offset setting and the second candidate offset setting based on which of the first measurement and the second measurement meets a noise-based criteria;
wherein the controller (114) is configured to perform the calibration process based on one or more of:
(i) a change, above a threshold, in a duty cycle of a switch of the switched mode DC-DC converter (102);
(ii) a change, above a threshold, in duty cycle, wherein the apparatus (100) includes a sensor configured to measure a duty cycle of the DC-DC converter (102);
(iii) a change, above a threshold, in current in the transmitter element (101), wherein the apparatus (100) includes a sensor configured to measure a current drawn by the transmitter element; and
(iv) a change, above a threshold, in a battery voltage wherein the DC-DC converter (102) receives the battery voltage as an input voltage for generating the output voltage.

2. The apparatus (100) of claim 1, wherein the noise-based criteria comprises one of:
which of the first measurement and the second measurement is indicative of lower noise in the receiver path (111); and
which of the first measurement and the second measurement is indicative of noise lower than a predetermined threshold level.

3. The apparatus (100) of claim 1 or claim 2, wherein the controller (114), by the acquiring of the first measurement using the first candidate offset setting and the second measurement using the second candidate offset setting, is configured to select the offset setting that provides for a change in state of a switch of the DC-DC converter (102), that is controlled by the switching schedule, that occurs at a different time to one or more of the sampling periods, wherein the offset setting defines a time offset applied to default timing of the sampling schedule for the receiver path (111).

4. The apparatus (100) of any preceding claim, wherein the receiver path (111) comprises an in-phase, I, path and a quadrature, Q, path and wherein the noise detector (113) comprises a first noise detector (508) configured to measure noise in the I path and a second noise detector (509) configured to measure noise in the Q path.

5. The apparatus (100) of any preceding claim, wherein the receiver path (100) comprises an in-phase, I, path and a quadrature, Q, path and wherein the noise detector (113) is configured to measure noise in one of the I path and the Q path.

6. The apparatus (100) of claim 4 or claim 5, wherein the controller (114) is configured to select said one of the first candidate offset setting and the second candidate offset setting further based on a receive path sampling condition comprising a peak sampling condition or a balanced sampling condition of the I path and the Q path.

7. The apparatus (100) of any preceding claim, wherein the controller (114) is configured to acquire one or more further measurements, by said noise detector, of noise in the receiver path (111) for one or more further candidate offset settings, the one or more further candidate offset settings each defining a different time offset applied to default timing of the sampling schedule for the receiver path; and
wherein the controller (114) is configured to select, for use in sampling the received signal, one of the first candidate offset setting, the second candidate offset setting and the one or more further candidate offset settings based on which of the first measurement, the second measurement, and one or more further measurements meets the noise-based criteria.

8. The apparatus (100) of any preceding claim, wherein the first time offset comprises zero and thereby the acquisition of the first measurement is based on an initial switching schedule and an initial sampling schedule, wherein the switching schedule defines at least when a switch of the DC-DC converter (102) changes state and the sampling schedule defines the points in time when the received signal is sampled over the plurality of sampling periods.

9. The apparatus (100) of any preceding claim, wherein the first measurement and the second measurement, and any further measurement, if present, comprises a measurement of noise variance.

10. The apparatus (100) of any preceding claim, wherein the appartus comprises a common clock (103) configured to provide a clock signal to the receiver path (111) and the DC-DC converter (102) for determination of the switching schedule and the sampling schedule.

11. The apparatus (100) of any preceding claim, wherein the transmitter element (101), the switched mode DC-DC converter (102) and the receiver path (111) are provided in a single die (112).

12. The apparatus (100) of any preceding claim, wherein the transmitter element (101) is configured to one or both of: generate the magnetic field to energise a near-field communication, NFC, target; and generate the electromagnetic signal to communicate with a radio-frequency identification, RFID, tag.

13. An electronic device including the apparatus (100) of any preceding claim configured to read one or both of an NFC target and a RFID tag.
